(19) Europäisches Patentamt / European Patent Office / Office européen des brevets

(11) **EP 4 626 145 B1**

(12) **EUROPEAN PATENT SPECIFICATION**

(45) Date of publication and mention
of the grant of the patent:
**22.07.2026 Bulletin 2026/30**

(21) Application number: **25158756.4**

(22) Date of filing: **19.02.2025**

(51) International Patent Classification (IPC):
*H02M 7/487* (2007.01)      *H05K 1/02* (2006.01)
*H05K 1/185* (2026.01)      *H10W 70/60* (2026.01)

(52) Cooperative Patent Classification (CPC):
**H05K 1/185; H02M 7/003; H02M 7/487;**
**H05K 1/0231; H10W 70/614; H10W 90/00;**
H05K 1/0263; H05K 2201/10015; H05K 2201/10166

(54) **INVERTER DEVICE**

WECHSELRICHTER

DISPOSITIF ONDULEUR

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **27.03.2024 JP 2024052396**

(43) Date of publication of application:
**01.10.2025 Bulletin 2025/40**

(73) Proprietor: **MAZDA MOTOR CORPORATION**
**Hiroshima 730-8670 (JP)**

(72) Inventors:
• **Furukawa, Akihiro**
  **Aki-gun, Hiroshima, 730-8670 (JP)**
• **Togashi, Shigenori**
  **Kanagawa, 252- 0243 (JP)**

(74) Representative: **Lorenz Seidler Gossel Part. mbB**
**Widenmayerstr. 23**
**80538 München (DE)**

(56) References cited:
WO-A1-2014/202282      CN-A- 117 716 617
US-A1- 2019 274 219

**Description**

BACKGROUND

The technology disclosed herein belongs to a technical field related to an inverter device.

As inverter devices are becoming increasingly higher in power output with the improvement in power density, a technology for reducing the inductance of the inverter devices is being required.

Japanese Unexamined Patent Publication No. 2003-259656 describes a technology in which, in an inverter of DC-AC conversion, in order to reduce the interconnect inductance, two interconnect conductors are placed in parallel and close to each other and currents in the opposite directions are passed through the conductors, whereby the interconnect inductance is reduced by the use of the mutual inductance.

WO 2014/202282 A1 discloses an inverter device having a substrate on which transistors are connected in half-bridge mode. Further inverters are known from CN 117 716 617 A and US 2019/274219 A1.

Conventional inverter devices are formed by mounting transistors on a surface of a substrate. However, in the mounting of transistors on a substrate surface, there arises a problem of failing to sufficiently reduce the self-inductance due to the influence of bonding wires connecting the transistors and the substrate.

In view of the above problem, an objective of the technology disclosed herein is providing an inverter device with a reduced inductance.

SUMMARY

According to the invention, an inverter device including the features of claim 1 is provided

By placing the first transistor and the second transistor so that one face of the first transistor and the other face of the second transistor are opposed to each other, that is, by placing the first transistor and the second transistor in positions opposite to each other, the first interconnect connecting the source of the first transistor and the drain of the second transistor can be made short and wide. This can reduce the interconnect inductance.

Moreover, since the first interconnect can be made wide, the number of vias connecting the source of the first transistor and the drain of the second transistor with the first interconnect can be increased, whereby the influence of the self-inductance due to vias can be reduced.

As described above, according to the technology disclosed herein, the inductance of an inverter device can be reduced.

BRIEF DESCRIPTION OF THE DRAWINGS

FIG. 1 is a circuit diagram of an inverter device.
FIG. 2 is a sectional side view showing an example of the configuration of the inverter device.
FIG. 3 is a plan view of the inverter device as viewed from above a second interconnect layer.
FIG. 4 is a bottom view of the inverter device as viewed from below a fifth interconnect layer.
FIG. 5 is a view for explaining the flow of a current in the inverter device of the embodiment.
FIG. 6 is a view for explaining the flow of a current in an inverter device of a comparative example.
FIG. 7 is a sectional side view, equivalent of FIG. 2, showing another configuration example of the inverter device.

DETAILED DESCRIPTION

An illustrative embodiment will be described hereinafter with reference to the accompanying drawings. Note that the following description of the embodiment is merely illustrative essentially and will be made centering on the configuration related to the subject matter of the technology disclosed. Also, although technical elements different from the subject matter of the technology disclosed may be illustrated or described briefly, or description of such elements may be omitted, this will never be intended to limit the scope of the technology disclosed. In the present disclosure, the term "connection" is used as a concept broadly encompassing the state of being electrically connected. For example, the term "connection" includes, not only the case of direct connection between elements, but also the case of indirect connection between elements through a via or the like.

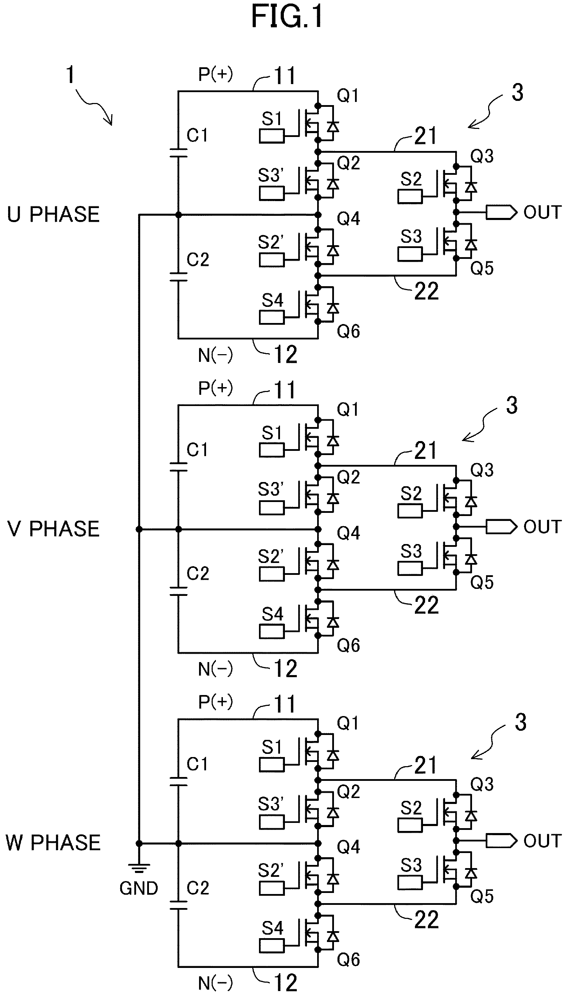

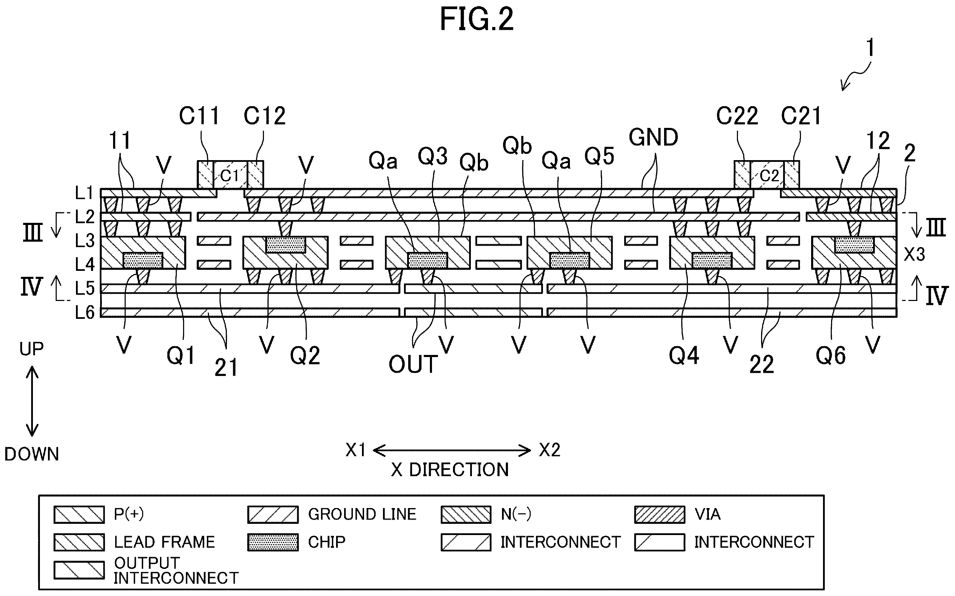

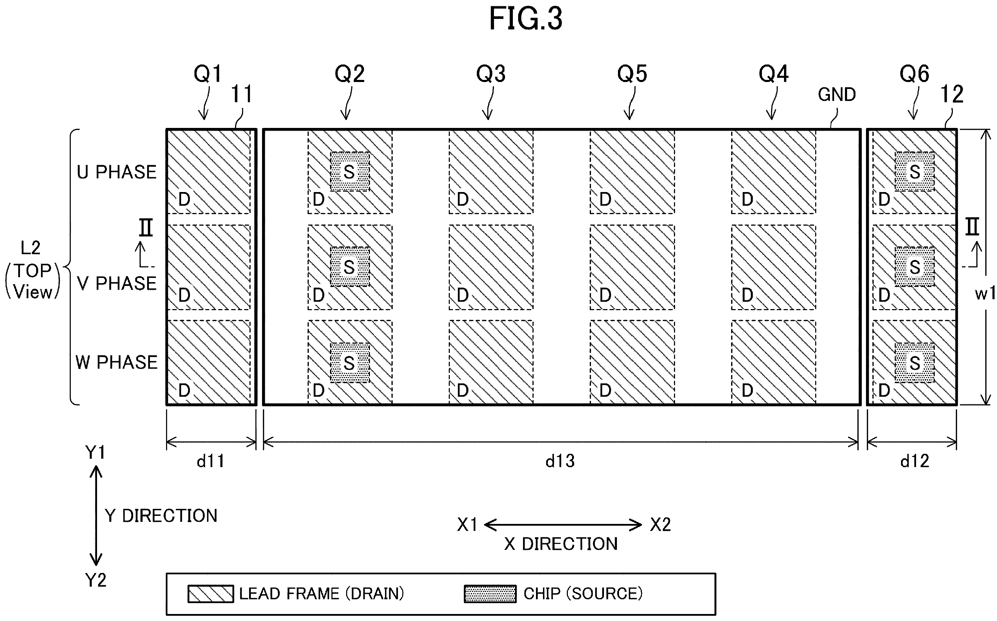

FIG. 1 is a circuit diagram of an inverter device 1 according to the embodiment. FIG. 2 is a sectional side view (e.g., a cross-sectional view taken along line II-II in FIG. 3) showing a configuration of the inverter device 1.

As shown in FIG. 1, in this example, the inverter device 1 is a 3-level inverter that outputs AC of three phases (U phase, V phase, and W phase) from a DC power supply such as a battery (not shown). The uses of the inverter device 1 are not specifically limited, but include driving of automobiles and actuation of engines (e.g., an integrated starter generator (ISG)), for example.

As shown in FIGS. 1 and 2, the inverter device 1 includes an interconnect substrate 2 and inverter circuits 3 of three phases (U phase, V phase, and W phase) mounted in the interconnect substrate 2. The inverter circuit 3 of each phase includes transistors Q1 to Q6, a first capacitor C1, and a second capacitor C2. Note that, in the following description, the transistors Q1 to Q6 may be collectively called the "transistors Q" when no distinction is made among them.

-Interconnect Substrate-

The interconnect substrate 2 is a multi-layer interconnect substrate (e.g., a printed board) having six interconnect layers, for example. For convenience of description, as shown in FIG. 2, the thickness direction of the interconnect substrate 2 is defined as the up/down direction, and the interconnect layer (first interconnect layer) having the principal surface (uppermost face) on which the first capacitor C1 and the second capacitor C2 are placed is called an interconnect layer L1. From the interconnect layer L1 downward, interconnect layers L2 to L6 (second to sixth interconnect layers) are formed in this order with an insulating layer (e.g., a layer formed of resin) interposed between every adjacent interconnect layers. From the standpoint of improving heat dissipation performance, it is preferable to use a glass epoxy resin or a high thermal conductive resin for the insulating layer between the interconnect layer L5 and the interconnect layer L6.

-Capacitor-

The first capacitor C1 is provided between a first power line 11 to which a positive power supply voltage P(+) is supplied from a battery (not shown) or the like and a ground line GND that is grounded. The second capacitor C2 is provided between the ground line GND and a second power line 12 to which a negative power supply voltage N(-) is supplied from a battery (not shown) or the like.

-Transistor-

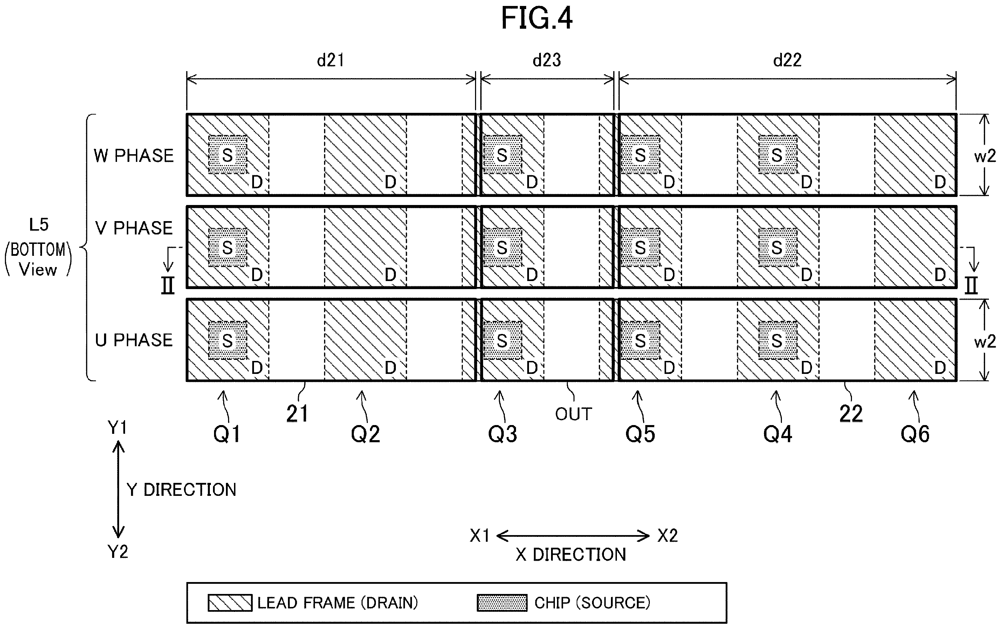

FIG. 3 is a plan view of the inverter device 1 as viewed from above the interconnect layer L2, and FIG. 4 is a bottom view of the inverter device 1 as viewed from below the interconnect layer L5. In FIGS. 3 and 4, the positions of the transistors Q1 to Q6 are indicated by the broken lines. Note that, as shown in FIGS. 3 and 4, the X direction and the Y direction are defined as directions perpendicular to the up/down direction and also directions orthogonal to each other. Also, in the following description, out of the X direction, the leftward direction in FIG. 3 may be called the X1 direction and the rightward direction in FIG. 3 called the X2 direction. Also, out of the Y direction, the upward direction in FIG. 3 may be called the Y1 direction and the downward direction in FIG. 3 called the Y2 direction. The X direction corresponds to the first direction, and the Y direction corresponds to the second direction. Note that the up/down direction, the X direction, and the Y direction are directions set for convenience of description, which are mere illustrations introduced for brevity of the description and by no means intended to limit the structure of the inverter device 1.

As shown in FIGS. 2 to 4, the transistors Q1 to Q6 of three phases are placed in a middle layer between the interconnect layer L2 and the interconnect layer L5. In this example, the interconnect layer L3, the interconnect layer L4, and an insulating layer X3 between L3 and L4 correspond to the "middle layer." The transistors Q1 to Q6 of three phases are arranged in the X-Y directions in the middle layer in planar view. More specifically, the transistors Q1 to Q6 of each phase are arranged in the X2 direction in the order of Q1, Q2, Q3, Q5, Q4, and Q6 in the middle layer. Moreover, the set of the transistors Q1 to Q6 of U phase, the set of the transistors Q1 to Q6 of V phase, and the set of the transistors Q1 to Q6 of W phase are arranged in the Y2 direction in the order of U phase, V phase, and W phase. That is, in the inverter circuit 3 of each phase, the transistors Q1 to Q6 are arranged linearly in the X direction in planar view. Also, the inverter circuits 3 of the three phases (U phase, V phase, and W phase) are arranged in the Y direction in planar view. Specifically, the transistor Q1 of U phase, the transistor Q1 of V phase, and the transistor Q1 of W phase are arranged linearly in the Y direction. This relationship also applies to the respective transistors Q2 to Q6 of the phases (U phase, V phase, and W phase).

The transistors Q are each an n-type power MOSFET of a vertical structure, and in this example, constituted by a semiconductor chip Qa (simply indicated as a "chip" in the figures) and a lead frame Qb. The semiconductor chip Qa has a source on one face and a drain on the other face. The lead frame Qb, made of copper, for example, is formed to have a U-shape in sectional side view (see FIG. 2) to cover the other face (drain) of the semiconductor chip Qa, and connected to the drain of the semiconductor chip Qa. That is, the lead frame Qb and the drain of the semiconductor chip Qa have the same potential.

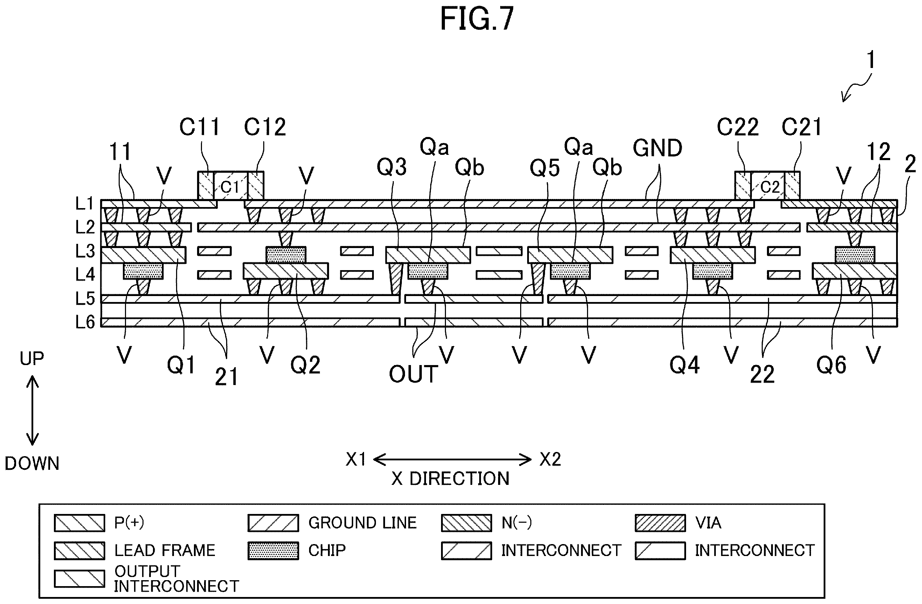

In other words, the transistor Q has a source region S and a drain region D surrounding the source region S on one face and has the drain region D on the other face. In the following description, the one face is called the "source-drain face" and the other face is called the "drain face." Note that the "one face (source-drain face)" and the "other face (drain face)" as used herein are not limited to be flat faces. Specifically, for example, as will be described with reference to FIG. 7 later, there may be a step (vertical step in FIG. 7) on the source-drain face between the face on which the source is provided and the face on which the drain is provided. As another example, part of the face on which the source is provided and/or the face on which the drain is provided may be inflated or dented. Note that the gate of the transistor Q is formed on the source-drain face of the semiconductor chip Qa although illustration is omitted because it falls outside the subject matter of the technology disclosed.

Note that the source and drain of each transistor Q and interconnects formed in the interconnect layers L2 and L5 are connected through a plurality of vias V and the lead frame Qb. For convenience of description, however, description of the connections through the vias V and the lead frame Qb may be omitted hereinafter. This also applies to connections of interconnects between the interconnect layers: i.e., illustration and/or description of connections through vias V and lead frames Qb may be omitted. Note also that, in FIG. 2, for easy understanding of the drawing, common hatching is given to interconnects to which a common signal or voltage is applied. In other words, in FIG. 2, interconnects under common hatching are mutually connected through vias and the like (whether shown or not shown).

The transistors Q1 to Q6 will be described individually hereinafter. Since the configurations of the transistors Q1 to Q6 are the same among U phase, V phase, and W phase, description here will be made for one phase only.

As shown in FIG. 2, the transistor Q1 is placed with the source-drain face facing the interconnect layer L5 and the drain face facing the interconnect layer L2, that is, positioned with the drain face facing upward. In the transistor Q1, the source terminal (hereinafter simply called the "source") is connected to an interconnect 21 in the interconnect layer L5, and the drain terminal (hereinafter simply called the "drain") on the drain face is connected to the first power line 11 in the interconnect layer L2.

The transistor Q2 is placed with the drain face facing the interconnect layer L5 and the source-drain face facing the interconnect layer L2, that is, positioned with the source-drain face facing upward. In the transistor Q2, the source is connected to the ground line GND in the interconnect layer L2, and the drain on the drain face is connected to the interconnect 21 in the interconnect layer L5.

The transistor Q3 is placed with the source-drain face facing the interconnect layer L5 and the drain face facing the interconnect layer L2, that is, positioned with the drain face facing upward. In the transistor Q3, the source is connected to an output interconnect OUT in the interconnect layer L5, and the drain on the X1-direction side (side closer to the transistor Q2) of the source-drain face is connected to the interconnect 21 in the interconnect layer L5.

The transistor Q5 is placed with the source-drain face facing the interconnect layer L5 and the drain face facing the interconnect layer L2, that is, positioned with the drain face facing upward. In the transistor Q5, the source is connected to an interconnect 22 in the interconnect layer L5, and the drain on the X1-direction side (side closer to the transistor Q3) of the source-drain face is connected to the output interconnect OUT in the interconnect layer L5.

The transistor Q4 is placed with the source-drain face facing the interconnect layer L5 and the drain face facing the interconnect layer L2, that is, positioned with the drain face facing upward. In the transistor Q4, the source is connected to the interconnect 22 in the interconnect layer L5, and the drain on the drain face is connected to the ground line GND in the interconnect layer L2.

The transistor Q6 is placed with the drain face facing the interconnect layer L5 and the source-drain face facing the interconnect layer L2, that is, positioned with the source-drain face facing upward. In the transistor Q6, the source is connected to the second power line 12 in the interconnect layer L2, and the drain on the drain face is connected to the interconnect 22 in the interconnect layer L5.

-Interconnect-

The first power line 11 is connected to a terminal C11 of the first capacitor C1 in the interconnect layer L1. Also, as described above, the first power line 11 in the interconnect layer L2 and the drain of the transistor Q1 are connected to each other. That is, the first power line 11 is constituted by interconnects formed in the interconnect layer L1 and the interconnect layer L2, and, in the interconnect layer L2, the interconnect has a length d11 and a width w1 as shown in FIG. 3. The width w1 of the interconnect is not specifically limited, but set to be equal to or more than the total width of the transistors Q1 of U phase, V phase, and W phase arranged in the Y direction, for example. The length d11 of the interconnect is not specifically limited, but set to be equal to or more than the length of the transistor Q1 in the X direction, for example. In this example, the length d11 of the interconnect is larger than the length of the transistor Q1 in the X direction. The first power line 11 is a wide line for connecting the drain of the transistor Q1 of U phase, the drain of the transistor Q1 of V phase, and the drain of the transistor Q1 of W phase to the power supply P(+). The first power line 11 covers the drain of the transistor Q1 of U phase, the drain of the transistor Q1 of V phase, and the drain of the transistor Q1 of W phase in planar view. For example, FIG. 3 shows an example of the first power line 11 placed to cover the entire of the transistors Q1 of U phase, V phase, and W phase in planar view. The first power line 11 has a predetermined width (w1 in this example) and a predetermined length (d11 in this example). The first power line 11 is an interconnect having a rectangular shape, for example, in planar view. With the above configuration, the drains of the transistors Q1 of U phase, V phase, and W phase can be mutually connected with low impedance. Note that it is not essential for the first power line 11 to cover the entire of the transistors Q1 of U phase, V phase, and W phase in planar view. For example, the length d11 of the first power line 11 may be shorter than the length of the transistors Q1 in the X direction. Similarly, each end of the first power line 11 in the Y direction may be located inward of the end of the transistor Q1 of U phase in the Y1 direction or inward of the end of the transistor Q1 of W phase in the Y2 direction in planar view. That is, the width w1 of the first power line 11 may be narrower than the total width of the transistors Q1 of U phase, V phase, and W phase arranged in the Y direction.

Although not illustrated, the interconnect in the interconnect layer L1 is formed to cover the interconnect in the interconnect layer L2 in planar view. From the standpoint of generating a current in the X2 direction in the interconnect layer L1, the first power line 11 in the interconnect layer L1 extends longer in the X2 direction than the length d11 (see FIG. 2). The width of the first power line 11 in the interconnect layer L1 is w1, although the width of the first power line 11 may be different between the interconnect layer L1 and the interconnect layer L2.

The second power line 12 is connected to a terminal C21 of the second capacitor C2 in the interconnect layer L1. Also, as described above, the second power line 12 in the interconnect layer L2 and the source of the transistor Q6 are connected to each other. That is, the second power line 12 is constituted by interconnects formed in the interconnect layer L1 and the interconnect layer L2, and, in the interconnect layer L2, the interconnect has a length d12 and a width w1 as shown in FIG. 3. The length d12 of the interconnect is not specifically limited, but set to be equal to or more than the length of the transistor Q6 in the X direction, for example. In this example, the length d12 of the interconnect is larger than the length of the transistor Q6 in the X direction. The second power line 12 is a wide line for connecting the source of the transistor Q6 of U phase, the source of the transistor Q6 of V phase, and the source of the transistor Q6 of W phase to the power supply N(-). The second power line 12 covers the source of the transistor Q6 of U phase, the source of the transistor Q6 of V phase, and the source of the transistor Q6 of W phase in planar view. In the example of FIG. 3, the second power line 12 covers the entire of the transistors Q6 of U phase, V phase, and W phase in planar view. The second power line 12 has a predetermined width (w1 in this example) and a predetermined length (d12 in this example). The second power line 12 is an interconnect having a rectangular shape, for example, in planar view. With the above configuration, the sources of the transistors Q6 of U phase, V phase, and W phase can be mutually connected with low impedance. Note that it is not essential for the second power line 12 to cover the entire of the transistors Q6 of U phase, V phase, and W phase in planar view. For example, the length d12 of the second power line 12 may be shorter than the length of the transistors Q6 in the X direction. Similarly, each end of the second power line 12 in the Y direction may be located inward of the end of the transistor Q6 of U phase in the Y1 direction or inward of the end of the transistor Q6 of W phase in the Y2 direction in planar view. That is, the width w1 of the second power line 12 may be narrower than the total width of the transistors Q6 of U phase, V phase, and W phase arranged in the Y direction.

Although not illustrated, the interconnect in the interconnect layer L1 is formed to cover the interconnect in the interconnect layer L2 in planar view. From the standpoint of generating a current in the X1 direction in the interconnect layer L1, the second power line 12 in the interconnect layer L1 extends longer in the X1 direction than the length d12 (see FIG. 2). The width of the second power line 12 in the interconnect layer L1 is w1, although the width of the second power line 12 may be different between the interconnect layer L1 and the interconnect layer L2.

The ground line GND is connected to a terminal C12 of the first capacitor C1 and a terminal C22 of the second capacitor C2 in the interconnect layer L1. Also, as described above, the ground line GND in the interconnect layer L2 is connected to the source of the transistor Q2 and the drain of the transistor Q4. The ground line GND is mainly constituted by interconnects formed in the interconnect layer L1 and the interconnect layer L2, and, in the interconnect layer L2, the interconnect has a length d13 and a width w1 as shown in FIG. 3. The length d13 of the ground line GND is not specifically limited, but the ground line GND extends from a position protruding in the X1 direction from the end of the transistor Q2 in the X1 direction to a position protruding in the X2 direction from the end of the transistor Q4 in the X2 direction. That is, the ground line GND is formed to cover the transistors Q2, Q3, Q5, and Q4 in planar view. The length of the ground line GND in the interconnect layer L1 is shorter than d13, and the width thereof is w1. The width of the ground line GND may be different between the interconnect layer L1 and the interconnect layer L2. The ground line GND may be provided in the interconnect layer L3 and/or the interconnect layer L4. The ground line GND is a wide line for mutually connecting the sources of the transistors Q2 of U phase, V phase, and W phase and the drains of the transistors Q4 of U phase, V phase, and W phase. The ground line GND covers the sources of the transistors Q2 of U phase, V phase, and W phase and the drains of the transistors Q4 of U phase, V phase, and W phase in planar view. In the example of FIG. 3, the ground line GND covers the entire of the transistors Q2, Q3, Q4, and Q5 of U phase, V phase, and W phase in planar view. The ground line GND has a predetermined width (w1 in this example) and a predetermined length (d13 in this example). The ground line GND is an interconnect having a rectangular shape, for example, in planar view. With the above configuration, the ground line GND and the transistors can be connected with low impedance. Note that it is not essential for the ground line GND to cover the entire of the transistors Q2, Q3, Q4, and Q5 of U phase, V phase, and W phase in planar view. For example, each end of the ground line GND in the X direction may be located inward of the end of the transistor Q2 of each phase in the X1 direction or inward of the end of the transistor Q4 of each phase in the X2 direction in planar view. That is, the length d13 of the ground line GND may be narrower than the total length of the transistors Q2, Q3, Q4, and Q5 arranged in the X direction. Similarly, each end of the ground line GND in the Y direction may be located inward of the end of each transistor of U phase in the Y1 direction or inward of the end of each transistor of W phase in the Y2 direction in planar view. That is, the width w1 of the ground line GND may be narrower than the total width of the transistors of U phase, V phase, and W phase arranged in the Y direction.

The interconnect 21 is constituted by interconnects formed in the interconnect layer L5 and the interconnect layer L6, and extends from the end of the transistor Q1 in the X1 direction to the drain region D (region in which the drain is provided) on the X1-direction side (side closer to the transistor Q2) of the source-drain face of the transistor Q3, for example. The interconnect 21 is an interconnect having a rectangular shape placed to cover the source region S of the transistor Q1, the drain region D of the transistor Q2, and the drain region D on the X1-direction side of the transistor Q3 in planar view for each of U phase, V phase, and W phase, for example. The interconnect 21 connects the source of the transistor Q1, the drain of the transistor Q2, and the drain of the transistor Q3 to one another for each of U phase, V phase, and W phase. The interconnects 21 for U phase, V phase, and W phase are separated from one another. As shown in FIG. 4, in the interconnect layer L5, the length of the interconnect 21 is d21 and the width thereof is w2. The length d21 of the interconnect is not limited to that shown in FIG. 4. For example, the length d21 of the interconnect in the X1 direction may be made longer than in FIG. 4, or made shorter to end at some midpoint of the transistor Q1. Note however that, from the standpoint of reducing the influence of the inductance of the via V connecting the transistor Q1 and the interconnect 21, it is preferable to increase the overlap areas of the interconnect 21 with the source of the transistor Q1, the drain of the transistor Q2, and the drain of the transistor Q3 in planar view.

The output interconnect OUT is constituted by interconnects formed in the interconnect layer L5 and the interconnect layer L6. The output interconnect OUT extends from the end of the source of the transistor Q3 in the X1 direction to the drain region D on the X1-direction side (side closer to the transistor Q3) of the source-drain face of the transistor Q5, for example. The output interconnect OUT is an interconnect having a rectangular shape placed to cover the source region S of the transistor Q3 and the drain region D on the X1-direction side of the transistor Q5 in planar view for each of U phase, V phase, and W phase. The output interconnect OUT connects the source of the transistor Q3 and the drain of the transistor Q4 to each other. The output interconnects OUT for U phase, V phase, and W phase are separated from one another. The power of each phase of the inverter device 1 is output from the output interconnect OUT.

The interconnect 22 is constituted by interconnects formed in the interconnect layer L5 and the interconnect layer L6, and extends from the end of the source region S (region in which the source is provided) of the transistor Q5 in the X1 direction to the end of the transistor Q6 in the X2 direction, for example. The interconnect 22 is an interconnect having a rectangular shape placed to cover the source region S of the transistor Q5, the source region S of the transistor Q4, and the drain region D of the transistor Q6 in planar view for each of U phase, V phase, and W phase, for example. The interconnect 22 connects the source of the transistor Q5, the source of the transistor Q4, and the drain of the transistor Q6 to one another for each of U phase, V phase, and W phase. The interconnects 22 for U phase, V phase, and W phase are separated from one another. As shown in FIG. 4, the length of the interconnect 22 is d22 and the width thereof is w2. The length d22 of the interconnect 22 is not limited to that shown in FIG. 4. For example, the length d22 of the interconnect 22 in the X2 direction may be made longer than in FIG. 4, or made shorter to end at some midpoint of the transistor Q6. Note however that, from the standpoint of reducing the influence of the inductance of the vias V connecting the transistor Q6 and the interconnect 22, it is preferable to increase the overlap areas of the interconnect 22 with the source of the transistor Q5, the source of the transistor Q4, and the drain of the transistor Q6 in planar view.

Although illustration is omitted, the interconnects 21 in the interconnect layer L5 and the interconnect layer L6 are the same in size and shape in planar view, and are mutually connected through vias V. This also applies to the output interconnect OUT and the interconnect 22.

-Effects of Embodiment-

As described above, the inverter device 1 of this embodiment includes: the interconnect substrate 2 having the first interconnect layer and the second interconnect layer; and a plurality of transistors Q each having a source on one face (source-drain face) and a drain on the other face (drain face). The plurality of transistors Q are arranged in the middle layer between the first interconnect layer and the second interconnect layer of the interconnect substrate 2. The plurality of transistors Q include a first transistor placed with the one face facing the first interconnect layer and a second transistor placed with the other face facing the first interconnect layer. The source of the first transistor and the drain of the second transistor are connected through a first interconnect in the first interconnect layer.

Specifically, in this embodiment, for example, in the relationship of the transistor Q1 and the transistor Q2 with the interconnect layer L5, the transistor Q1 is placed with its source-drain face facing the interconnect layer L5, and the transistor Q2 is placed with its drain face facing the interconnect layer L5. The source of the transistor Q1 and the drain of the transistor Q2 are connected through the interconnect 21 in the interconnect layer L5. In this case, the transistor Q1 corresponds to the first transistor, the transistor Q2 corresponds to the second transistor, the interconnect layer L5 corresponds to the first interconnect layer, and the interconnect 21 corresponds to the first interconnect.

As described above, by changing the face facing the interconnect layer L5 between the transistor Q1 and the transistor Q2, the interconnect 21 between the source of the transistor Q1 and the drain of the transistor Q2 can be made short and wide. Here, as indicated by the following approximate expression, the interconnect inductance of the interconnect substrate 2 is proportional to the interconnect length L and inversely proportional to the interconnect width W. That is, with the configuration of this embodiment, the interconnect inductance can be reduced.

$$INDUCTANCE = 0.0002[\ln \frac{2L}{(W+H)} + 0.2235 \left(\frac{W+H}{L}\right) + 0.5]$$

where H denotes the thickness of the interconnect (e.g., copper foil) formed in the interconnect layer.

Moreover, since the interconnect 21 can be widened, the number of vias connecting the transistors Q1 and Q2 with the interconnect 21 can be increased. This can reduce the influence of the self-inductance due to connection through vias.

Similarly, in the relationship of the transistor Q4 and the transistor Q6 with the interconnect layer L5, the transistor Q4 is placed with its source-drain face facing the interconnect layer L5, and the transistor Q6 is placed with its drain face facing the interconnect layer L5. The source of the transistor Q4 and the drain of the transistor Q6 are connected through the interconnect 22 in the interconnect layer L5. In this case, the transistor Q4 corresponds to the first transistor, the transistor Q6 corresponds to the second transistor, the interconnect layer L5 corresponds to the first interconnect layer, and the interconnect 22 corresponds to the first interconnect. Therefore, effects similar to those in the case of the relationship of the transistor Q1 and the transistor Q2 with the interconnect layer L5 are obtained.

Also, in the relationship of the transistors Q4, Q5, and Q6 with the interconnect layer L5, the transistor Q5 is placed with its source-drain face facing the interconnect layer L5, in addition to the above placement. Moreover, the transistors Q4, Q5, and Q6 are arranged linearly. Therefore, the interconnect 22 connecting the source of the transistor Q5, the drain of the transistor Q6, and the source of the transistor Q4 can be made short and wide. In this case, the transistor Q5 corresponds to the third transistor.

By the way, in order to reduce the self-inductance, it is important to lay interconnects using no via as a current route. In relation to this, in this embodiment, consider the relationship of the transistor Q2 and the transistor Q4 with the interconnect layer L2, for example. The transistor Q2 is placed with its source-drain face facing the interconnect layer L2, and the transistor Q4 is placed with its drain face facing the interconnect layer L2. The source of the transistor Q2 and the drain of the transistor Q4 are connected through the ground line GND in the interconnect layer L2. And, as the interconnects for the transistors Q3 and Q5 placed between the transistor Q2 and the transistor Q4, the interconnect layer L5 is used.

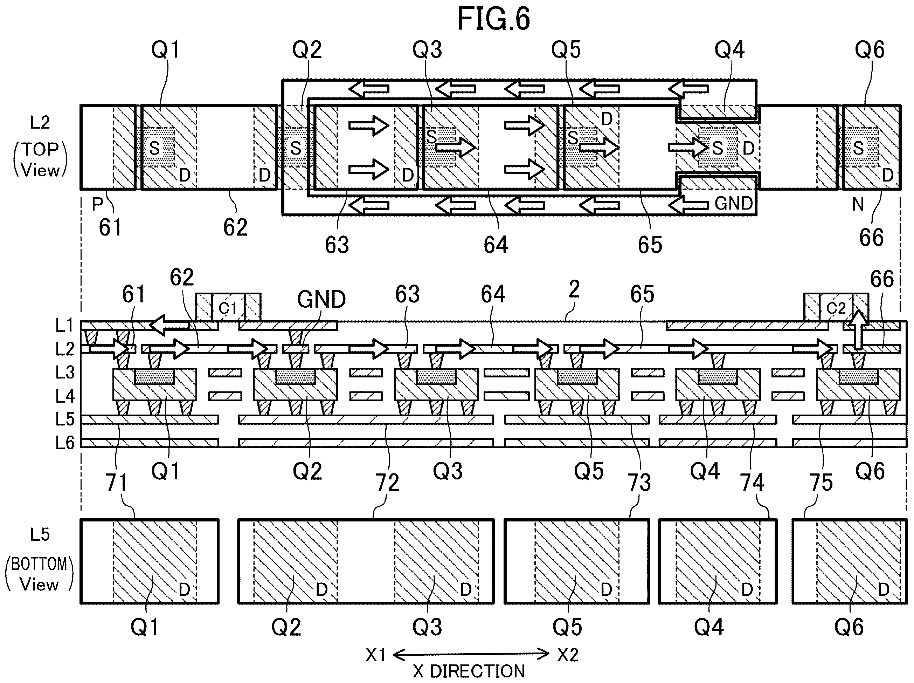

As described above, by changing the faces of the transistor Q2 and the transistor Q4 facing the interconnect layer L2 from each other, the ground line connected to the source of the transistor Q2 and the drain of the transistor Q4 can be set to be wide making the upmost use of the width of the interconnect substrate 2 in the Y direction. This will be described concretely referring to the related drawings. FIG. 6 shows an example in which the transistors Q1 to Q6 are embedded in the interconnect substrate 2 with their source-drain faces facing upward. Since the source of the transistor Q3 and the drain of the transistor Q5 are connected to the output interconnect OUT, it becomes necessary, in this example, to provide an output interconnect OUT in the interconnect layer L2. In this case, for a ground line connected to the source of the transistor Q2 and the drain of the transistor Q4, a detour must be provided as shown in FIG. 6 when the ground line is to be formed in the same interconnect layer. Otherwise, another interconnect layer (e.g., L6) must be used. In this case, in comparison with the configuration of this embodiment, a sufficient self-inductance reduction effect will not be obtained.

Also, in this embodiment, the transistor Q1, the transistor Q2, the transistor Q3, the transistor Q5, the transistor Q4, and the transistor Q6 are arranged in this order in the X2 direction in the middle layer of the interconnect substrate 2.

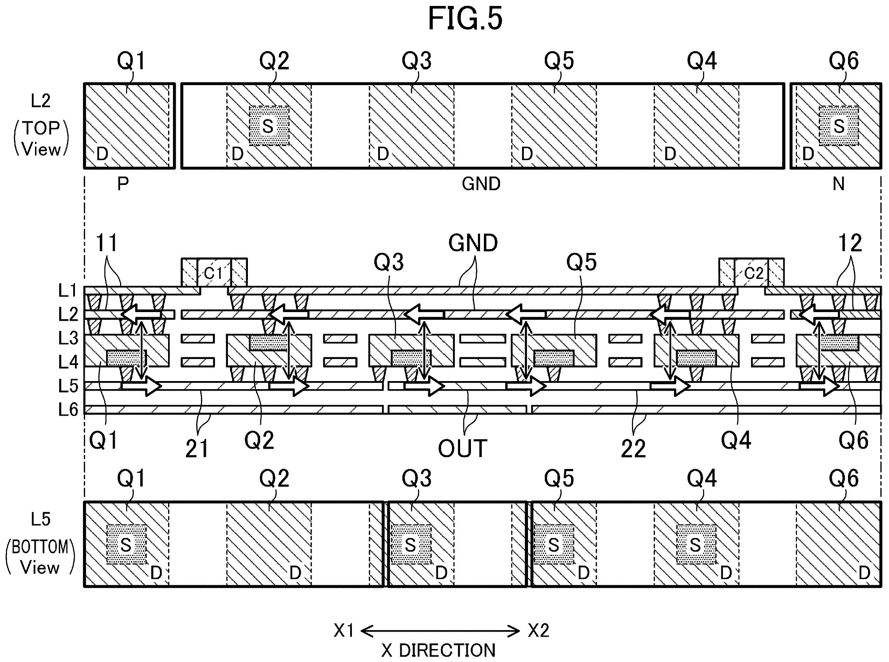

With the above configuration, the current routes flowing through the sources and drains of the transistors Q can be made to be parallel interconnects, thereby achieving low inductance by differential connections. Also, the configuration of this embodiment achieves current routes that are parallel and large in parallel width. This will be described with reference to FIGS. 5 and 6.

FIG. 5 is a combined illustration of a view equivalent of FIG. 3, a view equivalent of FIG. 2, and a view equivalent of FIG. 4 arranged from top to bottom, for one phase in this embodiment, in which, in the sectional side view, the direction in which a current flows is shown by the hollow arrows. In FIG. 5, as shown by the two-way arrows, the direction of the current flowing through the interconnect in the interconnect layer L2 is the opposite to the direction of the current flowing through the interconnect in the interconnect layer L5. This creates differential connection, and therefore a mutual inductance part is subtracted from the self-inductance, whereby the value of the synthetic inductance can be reduced.

By contrast, in the comparative example shown in FIG. 6, although the current in the ground line and the current in the interconnect laid in the middle of the ground line flow in the opposite directions, they are a loop interconnect and are not parallel interconnects between different interconnect layers. Therefore, the cross-sectional area to contribute to the reduction in inductance is narrow, so that the effect of reducing the value of the synthetic inductance due to differential connection is restrictive. Moreover, in the configuration of FIG. 6, in comparison with this embodiment, since the number of vias between the drains and the interconnects is small, the self-inductance increases. In this embodiment, however, since vias V can be provided on the entire drain faces of the transistors Q1, Q2, Q4, and Q6, the self-inductance can be reduced.

As described above, the inverter device 1 of this embodiment includes: the interconnect substrate 2 having the interconnect layer L5 and the interconnect layer L2; and a plurality of transistors Q each having a source on one face (source-drain face) and a drain on the other face (drain face). The plurality of transistors Q include the transistors Q1 to Q6 arranged in the middle layer between the interconnect layer L5 and the interconnect layer L2 of the interconnect substrate 2. In the transistor Q1, placed with the source-drain face facing the interconnect layer L5, the drain on the drain face is connected to the first power line 11 in the interconnect layer L2, and the source on the source-drain face is connected to the interconnect 21 in the interconnect layer L5. In the transistor Q2, placed with the drain face facing the interconnect layer L5, the source on the source-drain face is connected to the ground line GND in the interconnect layer L2, and the drain on the drain face is connected to the interconnect 21 in the interconnect layer L5. In the transistor Q3, placed with the source-drain face facing the interconnect layer L5, the source on the source-drain face is connected to the output interconnect OUT in the interconnect layer L5, and the drain on the source-drain face is connected to the interconnect 21 in the interconnect layer L5. In the transistor Q5, placed with the source-drain face facing the interconnect layer L5, the source on the source-drain face is connected to the interconnect 22 in the interconnect layer L5, and the drain on the source-drain face is connected to the output interconnect OUT in the interconnect layer L5. In the transistor Q4, placed with the source-drain face facing the interconnect layer L5, the source on the source-drain face is connected to the interconnect 22 in the interconnect layer L5, and the drain on the drain face is connected to the ground line GND in the interconnect layer L2. In the transistor Q6, placed with the drain face facing the interconnect layer L5, the drain on the drain face is connected to the interconnect 22 in the interconnect layer L5, and the source on the source-drain face is connected to the second power line 12 in the interconnect layer L2. In this case, the transistor Q1 corresponds to the first transistor, the transistor Q2 corresponds to the second transistor, the transistor Q3 corresponds to the third transistor, the transistor Q5 corresponds to the fourth transistor, the transistor Q4 corresponds to the fifth transistor, and the transistor Q6 corresponds to the sixth transistor. Also, the interconnect layer L5 corresponds to the first interconnect layer, the interconnect layer L2 corresponds to the second interconnect layer, the interconnect 21 corresponds to the first interconnect, the ground line GND corresponds to the second interconnect, and the interconnect 22 corresponds to the third interconnect.

Having the above configuration, as described above, the interconnect 21 between the source and drain of the transistors Q1 and Q2, and the interconnect 22 between the source and drain of the transistors Q4 and Q6, can be made short and wide. That is, the interconnect inductance of the inverter device 1 can be reduced.

Moreover, in the above embodiment, the inverter device 1 includes inverter circuits 3 of three phases (U phase, V phase, and W phase) each having the transistors Q1 to Q6. As shown in FIG. 3, the transistors Q1 to Q6 of each phase are arranged linearly in the X direction in planar view. Also, the inverter circuits 3 of U phase, V phase, and W phase are arranged in this order in the Y direction in planar view, and the ground lines GND for these phases are mutually connected in the interconnect layer L2.

As described above, by sharing the ground line, the interconnect inductance can be further reduced. Also, since current routes for mutually connecting the grounds among the inverter circuits 3 of three phases are formed, the inductance of the inverter device 1 is further reduced.

<Other Embodiments>

For example, the technology of the present disclosure can also be applied to inverter devices having circuit configurations other than that shown in FIG. 1. For example, in the above embodiment, the transistor Q2 and the transistor Q4 may be replaced with diodes (not shown). This corresponds to an illustrative example not being part of the invention as claimed.

In the above case, a diode (first diode) replacing the transistor Q2 has a cathode connected to the interconnect 21 in the interconnect layer L5 and an anode connected to the ground line GND in the interconnect layer L2. Similarly, a diode (second diode) replacing the transistor Q4 has a cathode connected to the ground line GND in the interconnect layer L2 and an anode connected to the interconnect 22 in the interconnect layer L5.

In the above configuration using the first diode and the second diode, in the relationship of the transistor Q5 and the transistor Q6 with the interconnect layer L5, for example, the transistor Q5 is placed with the source-drain face facing the interconnect layer L5 and the transistor Q6 is placed with the drain face facing the interconnect layer L5. The source of the transistor Q5 and the drain of the transistor Q6 are connected through the interconnect 22 in the interconnect layer L5. In this case, the transistor Q5 corresponds to the first transistor, the transistor Q6 corresponds to the second transistor, the interconnect layer L5 corresponds to the first interconnect layer, and the interconnect 22 corresponds to the first interconnect. With this, the interconnect 22 between the source and drain of the transistors Q5 and Q6 can be made short and wide, and therefore the interconnect inductance can be reduced.

Also, while the transistors Q each include the lead frame Qb having a U-shape in sectional side view as shown in FIG. 2 in the above embodiment, the shape is not limited to this. For example, as shown in FIG. 7, the lead frame Qb may have a rectangular shape longer on both sides in the X direction than the semiconductor chip Qa in sectional side view. In this case, the width in the Y direction may be made larger on both sides in the Y direction than that of the semiconductor chip Qa as in the above embodiment, or may be the same as that of the semiconductor chip Qa.

In the configuration of FIG. 7, also, the drain (lead frame Qb) on the drain-source face of the transistor Q3 and the interconnect 21 in the interconnect layer L5 are connected through a via V, for example. Similarly, the drain (lead frame Qb) on the drain-source face of the transistor Q5 and the output interconnect OUT in the interconnect layer L5 are connected through a via V. The other configuration is similar to that in FIG. 2. In the configuration of FIG. 7, also, effects similar to those in the above embodiment are obtained. Specifically, for example, the interconnect 21 and the interconnect 22 can be made short and wide, and therefore the interconnect inductance can be reduced.

In the above embodiments, while the transistors Q1 to Q6 for each phase are arranged linearly in the X direction, the linear arrangement of the transistors is not essential. For example, the positions of the transistors Q1 to Q6 for each phase in the Y direction may be displaced from one another.

The technology disclosed herein is very useful because the self-inductance of an inverter device can be reduced.

## Claims

1. An inverter device (1), comprising:

   an interconnect substrate (2) having a first interconnect layer (L5) and a second interconnect layer (L2); and
   a plurality of transistors (Q) arranged in a middle layer between the first interconnect layer (L5) and the second interconnect layer (L2), each having a source (S) and a drain (D) surrounding the source on one face and the drain on the other face,

   wherein
   the plurality of transistors (Q) include

   a first transistor (Q1) placed with the one face facing the first interconnect layer (L5), its source (S) being connected to a first interconnect (21) in the first interconnect layer (L5),
   a second transistor (Q2) placed with the other face facing the first interconnect layer (L5), its source (S) being connected to a second interconnect (GND) in the second interconnect layer (L2) and its drain (D) being connected to the first interconnect (21),
   a third transistor (Q3) placed with the one face facing the first interconnect layer (L5), its source (S) being connected to an output interconnect (OUT) in the first interconnect layer (L5) and its drain (D) connected to the first interconnect (21),
   a fourth transistor (Q5) placed with the one face facing the first interconnect layer (L5), its source (S) being connected to a third interconnect (22) in the first interconnect layer (L5) and its drain (D) connected to the output interconnect (OUT),
   a fifth transistor (Q4) placed with the one face facing the first interconnect layer (L5), its source (S) being connected to the third interconnect (22) and its drain (D) connected to the second interconnect (GND), and
   a sixth transistor (Q6) placed with the other face facing the first interconnect layer (L5), its drain (D) being connected to the third interconnect (22).

2. The inverter device (1) of claim 1, wherein

   the inverter device (1) includes inverter circuits (3) of three phases (U, V, W) each including the plurality of transistors (Q),
   in each of the inverter circuits (3), the plurality of transistors (Q) are arranged linearly in a first direction (X) in planar view, and
   the inverter circuits (3) of three phases (U, V, W) are arranged in a second direction (Y) orthogonal to the first direction (X) in planar view, and the second interconnects (GND) for the three phases (U, V, W) are mutually connected in the second interconnect layer (L2).

## Patentansprüche

1. Wechselrichtervorrichtung (1), umfassend:

ein Verdrahtungssubstrat (2), das eine erste Verdrahtungsschicht (L5) und eine zweite Verdrahtungsschicht (L2) aufweist; und

eine Mehrzahl von Transistoren (Q), die in einer mittleren Schicht zwischen der ersten Verdrahtungsschicht (L5) und der zweiten Verdrahtungsschicht (L2) angeordnet sind, die jeweils eine Source (S) und einen Drain (D) aufweisen, welche die Source auf einer Fläche und den Drain auf der anderen Fläche umgeben, wobei die Mehrzahl von Transistoren (Q) umfasst:

einen ersten Transistor (Q1), der derart angeordnet ist, dass die eine Fläche der ersten Verdrahtungsschicht (L5) zugewandt ist, wobei seine Source (S) mit einer ersten Verdrahtung (21) in der ersten Verdrahtungsschicht (L5) verbunden ist,

einen zweiten Transistor (Q2), der derart angeordnet ist, dass die andere Fläche der ersten Verdrahtungsschicht (L5) zugewandt ist, wobei seine Source (S) mit einer zweiten Verdrahtung (GND) in der zweiten Verdrahtungsschicht (L2) verbunden ist und sein Drain (D) mit der ersten Verdrahtung (21) verbunden ist,

einen dritten Transistor (Q3), der derart angeordnet ist, dass die eine Fläche der ersten Verdrahtungsschicht (L5) zugewandt ist, wobei seine Source (S) mit einer Ausgangsverdrahtung (OUT) in der ersten Verdrahtungsschicht (L5) verbunden ist und sein Drain (D) mit der ersten Verdrahtung (21) verbunden ist,

einen vierten Transistor (Q5), der derart angeordnet ist, dass die eine Fläche der ersten Verdrahtungsschicht (L5) zugewandt ist, wobei seine Source (S) mit einer dritten Verdrahtung (22) in der ersten Verdrahtungsschicht (L5) verbunden ist und sein Drain (D) mit der Ausgangsverdrahtung (OUT) verbunden ist,

einen fünften Transistor (Q4), der derart angeordnet ist, dass die eine Fläche der ersten Verdrahtungsschicht (L5) zugewandt ist, wobei seine Source (S) mit der dritten Verdrahtung (22) verbunden ist und sein Drain (D) mit der zweiten Verdrahtung (GND) verbunden ist, und

einen sechsten Transistor (Q6), der derart angeordnet ist, dass die andere Fläche der ersten Verdrahtungsschicht (L5) zugewandt ist, wobei sein Drain (D) mit der dritten Verdrahtung (22) verbunden ist.

2. Wechselrichtervorrichtung (1) nach Anspruch 1, wobei

die Wechselrichtervorrichtung (1) Wechselrichterschaltungen (3) mit drei Phasen (U, V, W) umfasst, die jeweils die Mehrzahl von Transistoren (Q) umfassen,

in jeder der Wechselrichterschaltungen (3) die Mehrzahl von Transistoren (Q) in einer ersten Richtung (X) in der Draufsicht linear angeordnet ist, und

die Wechselrichterschaltungen (3) der drei Phasen (U, V, W) in einer zweiten Richtung (Y), die orthogonal zu der ersten Richtung (X) ist, in der Draufsicht angeordnet sind, und die zweiten Verdrahtungen (GND) für die drei Phasen (U, V, W) in der zweiten Verdrahtungsschicht (L2) miteinander verbunden sind.

**Revendications**

1. Dispositif onduleur (1), comprenant :

un substrat d'interconnexion (2) comportant une première couche d'interconnexion (L5) et une deuxième couche d'interconnexion (L2) ; et

une pluralité de transistors (Q) disposés dans une couche intermédiaire entre la première couche d'interconnexion (L5) et la deuxième couche d'interconnexion (L2), chacun ayant une source (S) et un drain (D), la source étant située sur une face et le drain sur l'autre face, dans lequel

la pluralité de transistors (Q) comprend :

un premier transistor (Q1) placé avec ladite une face faisant face à la première couche d'interconnexion (L5), sa source (S) étant connectée à une première interconnexion (21) dans la première couche d'interconnexion (L5),

un deuxième transistor (Q2) placé avec ladite autre face faisant face à la première couche d'interconnexion (L5), sa source (S) étant connectée à une deuxième interconnexion (GND) dans la deuxième couche d'interconnexion (L2) et son drain (D) étant connecté à la première interconnexion (21),

un troisième transistor (Q3) placé avec ladite une face faisant face à la première couche d'interconnexion (L5), sa source (S) étant connectée à une interconnexion de sortie (OUT) dans la première couche d'interconnexion (L5) et son drain (D) étant connecté à la première interconnexion (21),

un quatrième transistor (Q5) placé avec ladite une face faisant face à la première couche d'interconnexion (L5), sa source (S) étant connectée à une troisième interconnexion (22) dans la première couche d'interconnexion (L5) et son drain (D) étant connecté à l'interconnexion de sortie (OUT),

un cinquième transistor (Q4) placé avec ladite une face faisant face à la première couche d'interconnexion (L5), sa source (S) étant connectée à la troisième interconnexion (22) et son drain (D) étant connecté à la deuxième interconnexion (GND), et

un sixième transistor (Q6) placé avec ladite autre face faisant face à la première couche d'interconnexion (L5), son drain (D) étant connecté à la troisième interconnexion (22).

2. Dispositif onduleur (1) selon la revendication 1, dans lequel

le dispositif onduleur (1) comprend des circuits onduleurs (3) de trois phases (U, V, W), comprenant chacun la pluralité de transistors (Q),

dans chacun des circuits onduleurs (3), la pluralité de transistors (Q) est disposée linéairement dans une première direction (X) en vue en plan, et

les circuits onduleurs (3) des trois phases (U, V, W) sont disposés dans une deuxième direction (Y) orthogonale à la première direction (X) en vue en plan, et les deuxièmes interconnexions (GND) pour les trois phases (U, V, W) sont mutuellement connectées dans la deuxième couche d'interconnexion (L2).

# FIG.1

FIG.2

FIG.3

# FIG.4

EP 4 626 145 B1

# FIG.5

EP 4 626 145 B1

## FIG.6

EP 4 626 145 B1

# FIG.7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003259656 A
- WO 2014202282 A1
- CN 117716617 A
- US 2019274219 A1